# EUROPEAN PATENT APPLICATION

(11) **EP 3 537 705 A1**
(43) Date of publication of application: **11.09.2019**
(21) Application number: 17868138.3
(22) Date of filing: 28.06.2017
(51) Int. Cl.: H04N 5/232, G03B 17/56

(54) **SELFIE STICK AND METHOD FOR CONTROLLING PHOTOGRAPHING DEVICE BY MEANS OF SELFIE STICK**

(30) Priority: 04.11.2016 WO PCT/CN2016/104714
(71) Applicant: Shenzhen Royole Technologies Co., Ltd, Shenzhen, Guangdong 518115 (CN)
(72) Inventor: YU, Xin, Shenzhen Guangdong 518115 (CN); ZHANG, Xuan, Shenzhen Guangdong 518115 (CN)
(74) Representative: Mewburn Ellis LLP
(86) International application number: PCT/CN2017/090663
(87) International publication number: WO 2018/082322

(57) **Abstract**

A selfie stick includes a holding bracket, a handle, and a connecting part. The holding bracket is operated to fix a photographic device. The handle includes a flexible touch screen and a control module. The flexible touch screen is operated to detect touch operations. The control module is electrically coupled to the flexible touch screen and operated to send control signal to the photographic device in accordance with the touch operations. The connecting part is coupled between the holding bracket and the handle. The present disclosure further provides a method for controlling a photographic device using a selfie stick.

## Description

### TECHNICAL FIELD

The present disclosure relates to a photographing control field, more particularly to a selfie stick and a method for controlling a photographic device using the same.

### BACKGROUND

Physical buttons of a selfie stick are applied for controlling a mobile phone. The mobile phone is enabled to use a front camera or a rear camera for shooting. After the selfie stick is stretched, a certain distance exists between fingers of a user and the mobile phone, which causes a difficulty for the user to directly touch the mobile phone to adjust focal lengths. Therefore, it is difficult to take a satisfied picture when photographing many people or taking a selfie from a distant distance.

### SUMMARY

The technical problem of the present disclosure to be solved is to provide a selfie stick for adjusting shooting parameters or functions of a photographic device.

In addition, the invention also provides a method for controlling a photographic device using a selfie stick.

In order to achieve the above objectives, the following technical solutions are adopted in the embodiments of the present disclosure:

One aspect, an embodiment of the present disclosure provides a selfie stick, including:
a holding bracket operated to hold a photographic device;
a handle including a flexible touch screen and a control module, the flexible touch screen operated to detect touch operations thereon, and the control module electrically coupled to the flexible touch screen and operated to send control signals to the photographic device according to the touch operations; and
a connecting part connecting the holding bracket and the handle.

Another aspect, an embodiment of the present disclosure further provides a method for controlling a photographic device using a selfie stick, including:
touching the flexible touch screen of a handle of the selfie stick;
by a flexible touch screen, detecting touch operations and generating touch signals; and
by a control module, generating control signals in accordance with the touch signals and sending to the photographic device for controlling the photographic device.

Compared with the prior art, the present disclosure has the following beneficial effects:

Since different touch operations may be identified by the flexible touch screen, various shooting parameters or functions may be adjusted via different touch operations on the flexible touch screen performed by the user, such as focal length, diaphragm, color, flash. The disclosure solves the problem that single button of a selfie stick may just act as a shutter in prior art, but not adjust the shooting parameters. Shooting experience for the users is improved

### BRIEF DESCRIPTION OF THE DRAWINGS

In order to more clearly illustrate the technical solution of the present disclosure, the accompanying drawings required for describing the embodiments will be briefly described below. Apparently, the accompanying drawings in the following description are merely the embodiments of the present disclosure, and other drawings may be obtained by those skilled in the art according to these accompanying drawings without paying any creative labor.
FIG. 1 is a schematic view of a selfie stick provided by one exemplary embodiment of the present disclosure in use.
FIG. 2 is a structural schematic view of the selfie stick illustrated in FIG.1.
FIG. 3 is a structural schematic view of a handle of the selfie stick illustrated in FIG.1.
FIG. 4 is an exploded schematic view of the handle illustrated in FIG. 3.
FIG. 5 is a structural schematic view of a handling member illustrated in FIG.4.
FIG. 6 is another structural schematic view of the handling member illustrated in FIG.5.
FIG. 7 is an additional structural schematic view of the handling member illustrated in FIG.5.
FIG. 8 is a structural schematic view of a bracket of the handle illustrated in FIG.3.
FIG. 9 is another structural schematic view of the handle illustrated in FIG.3.
FIG. 10 is an additional structural schematic view of the handle illustrated in FIG.3.
FIG. 11 is a structural schematic view of a part of the handle illustrated in FIG.3.
FIG. 12 is an exploded schematic view of the structure illustrated in FIG.11 from another angle.
FIG. 13 is a first schematic view of a method for controlling a photographic device using a selfie stick provided by one exemplary embodiment of the present disclosure.
FIG. 14 is a second schematic view of a method for controlling a photographic device using a selfie stick provided by one exemplary embodiment of the present disclosure.
FIG. 15 is a third schematic view of a method for controlling a photographic device using a selfie stick provided by one exemplary embodiment of the present disclosure.
FIG. 16 is a fourth schematic view of a method for controlling a photographic device using a selfie stick provided by one exemplary embodiment of the present disclosure.

### DETAILED DESCRIPTION

The technical solutions in the embodiments of the present disclosure are clearly and completely described below with reference to the accompanying drawings in the embodiments of the present disclosure. Apparently, the described embodiments are merely some but not all of the embodiments of the present disclosure. All other embodiments obtained by a person of ordinary skill in the art based on the embodiments of the present disclosure without creative efforts shall fall within the protection scope of the present disclosure.

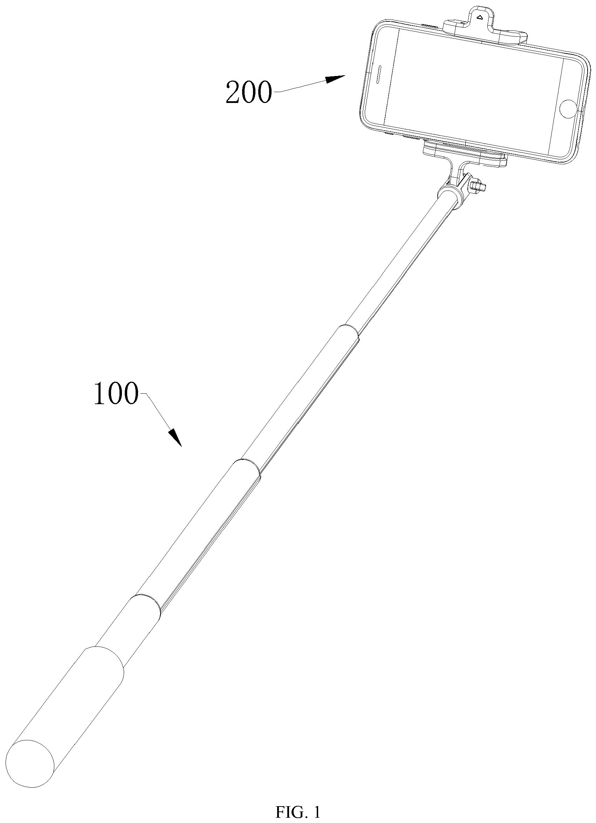

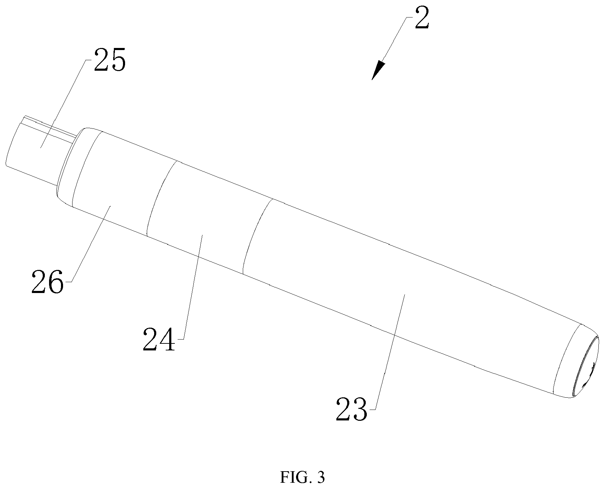

Referring to FIGS.1 to 4, a selfie stick 100 is provided by an exemplary embodiment of the present disclosure. The selfie stick 100 includes a holding bracket 1, a handle 2 and a connecting part 3. The holding bracket 1 is operated to hold a photographic device 200. The handle 2 includes a flexible touch screen 21 and a control module 22. The flexible touch screen 21 is operated to detect touch operations. The control module 22 is electrically coupled to the flexible touch screen 21. The control module 22 is operated to send control signals to the photographic device 200 according to the touch operations. The connecting part 3 is connected the holding bracket 1 and the handle 2. The connecting part 3 may be of a retractable or foldable structure, such as a pipe assembly or a rod assembly.

In the embodiment, the handle 2 of the selfie stick 100 provides the flexible screen 21 and the control module 22. A user may touch the flexible touch screen 21 when holding the handle 2 to take selfies. The flexible touch screen 21 is able to detect the touch operations thereon. In accordance with the touch operations, corresponding control signals are transmitted by the control module 22 to the photographic device 200 for control. Since different touch operations may be identified by the flexible touch screen 21, various shooting parameters or functions may be adjusted via different touch operations on the flexible touch screen performed by the user, such as focal length, diaphragm, color, flash. The disclosure solves the problem that single button of a selfie stick may just act as a shutter in prior art, but not adjust the shooting parameters in related art is solved. Shooting experience for the users is improved.

In other embodiments, controlling the photographic device 200 to perform different operations may be achieved via different touching operations on the flexible touch screen 21. For example, a photographic filter of the photographic device 200 may be switched via a horizontal slide operation. Focal length for photographing of the photographic device 200 may be adjusted via vertical slide operations. Cameras may be switched between a front camera and a rear camera of the photographic device 200 via a double-click operation. The photographic device 200 may take images via a long-press operation.

The photographic device 200 may be various mobile terminal having photographing functions, such as a mobile phone.

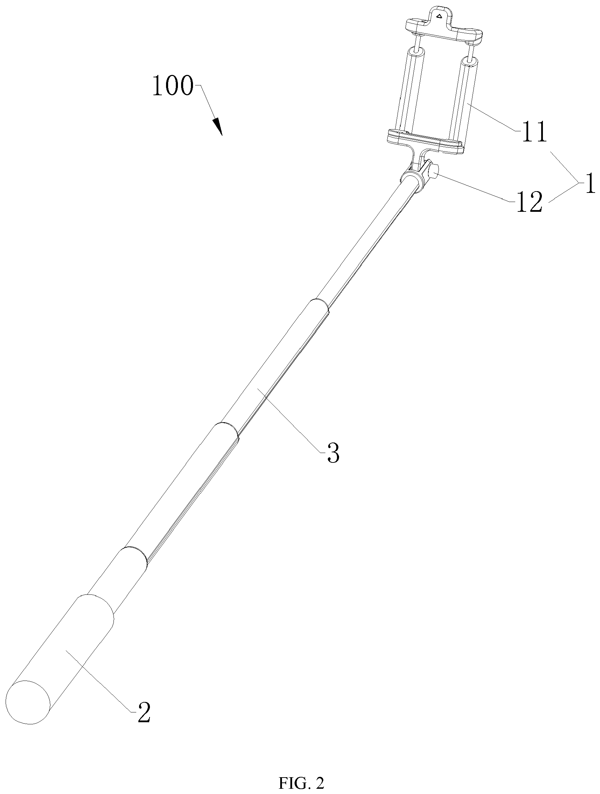

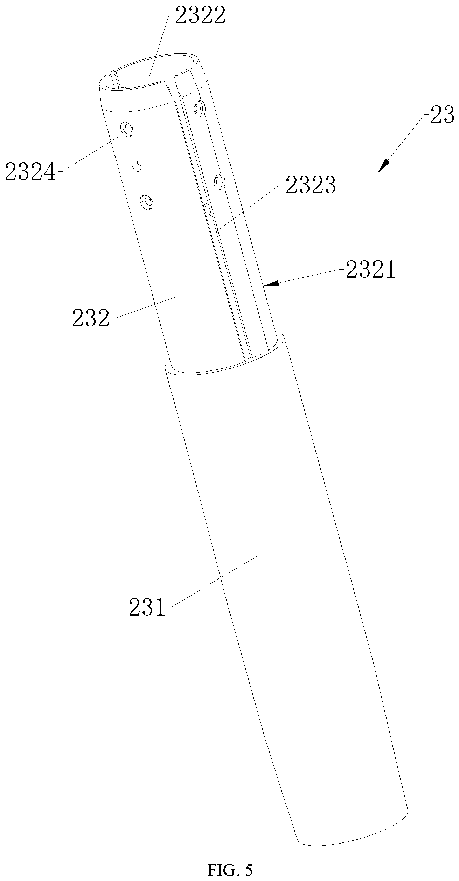

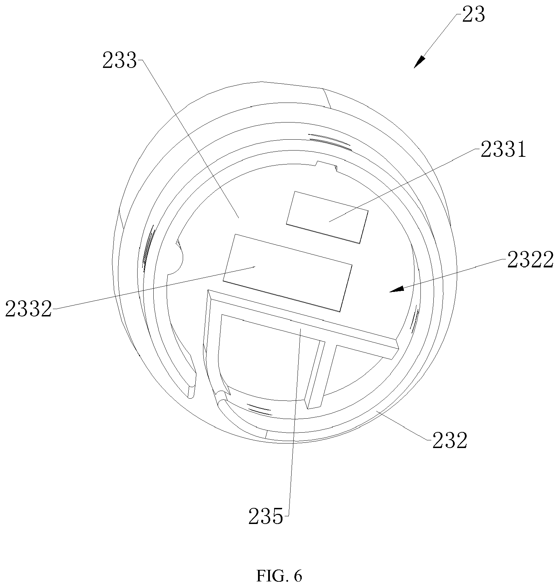

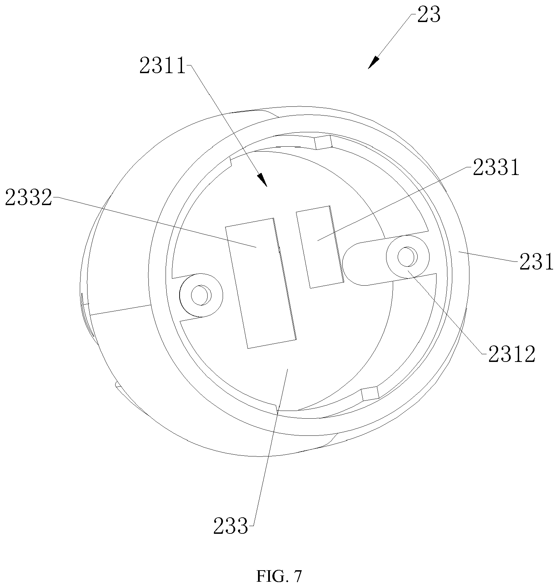

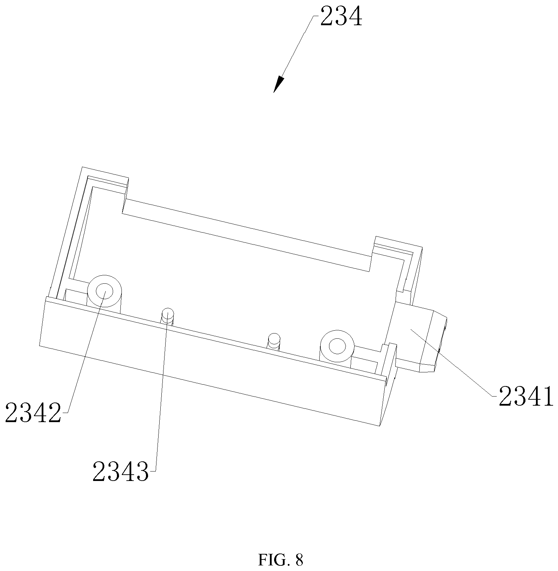

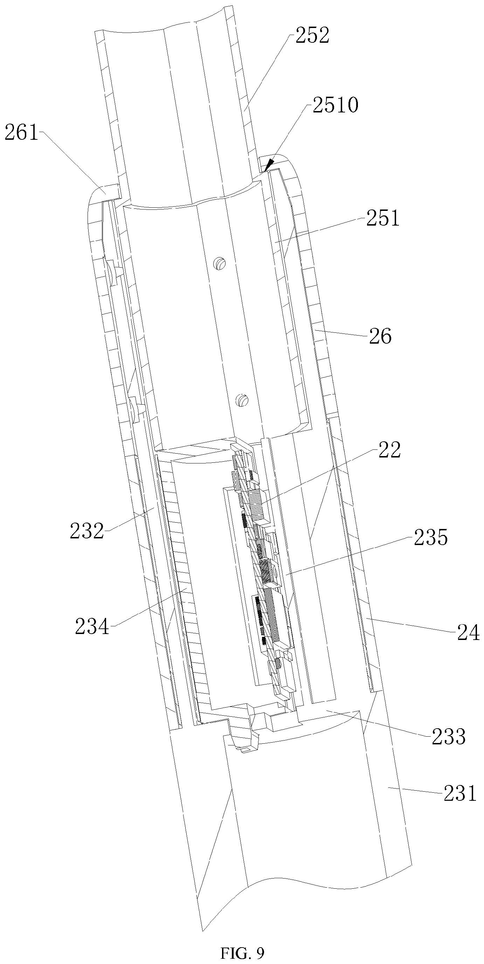

Further referring to FIGS.2 to 9, as an alternative embodiment, the handle 2 further includes a handling member 23. The handing member 23 includes a holding end 231 and a fixing end 232. The fixing end 232 is positioned between the holding end 231 and the connecting part 3. The flexible touch screen 21 is positioned around an outer surface 2321 of the fixing end 232. Then the flexible touch screen 21 is positioned between the holding end 231 and the connecting part 3.

In use of the selfie stick 100, the user may hold the holding end 231 and touch the flexible touch screen 21. The position of the flexible touch screen 21 positioned between the holding end 231 and the connecting part 3 fits user usage (including a usage of holding and touching with signal hand in the same time, and a usage of holding in one hand and touching with the other hand). Therefore, it is much more comfortable and convenient for users, improving user experience.

In other embodiments, the flexible touch screen 21 is fixed on the outer surface 2321 of the fixing end 232 via winding. The outer surface 2321 of the fixing end 232 is winded by the flexible touch screen 21 in one or less than one circle. A side of the flexible touch screen 21 is adhered to the outer surface 2321 of the fixing end 232 via a glue layer.

In other embodiments, the handle 2 includes a touching member 24. The touching member 24 is sleeved on the flexible touch screen 21 for protection. Then the touching member 24 is also sleeved on the fixing end 232. The touching member 24 is made of transparent and horniness material, such as plastic material. The flexible touch screen 21 includes a touching area facing the touching member 24. The flexible touch screen 21 may detect the touching operations performed on the touching area across the touching member 24.

In other embodiments, an interior of the fixing end 232 encloses a first space 2322. The fixing end 232 is of a hollow structure, such as a cylinder. A slot 2323 runs through the fixing end 232 for communicating the first space 233 with external of the fixing end 232. The flexible touch screen 21 extends into the first space 2322 via the slot 2322. Most of the flexible touch screen 21 surrounds the outer surface 2321 of the fixing end 232. An end of the flexible touch screen 21 extends into the first space 2322 via the slot 2323.

In other embodiments, the interior of the holding end 231 further encloses a second space 2311. The holding end 231 is of a hollow structure, such as a cylinder. The handling member 23 further includes a baffle 233 for separating the first space 2322 and the second space 2311. The baffle 233 is positioned between the holding end 231 and the fixing end 232 for separating the first space 2322 from the second space 2311. It is beneficial to utilize inner space of the handling member 23, reduce a volume of the selfie stick 100, and reduce manufacture cost of the selfie stick 100. The holding end 231 and the fixing end 232 are integrated in one body to reduce manufacture difficulty and cost.

In other embodiments, the handle 2 further includes a support 234. The support 234 is mounted in the first space 2322 for supporting the control module 22. The control module 22 is installed on the support 234 and positioned in the first space 2322. The flexible touch screen 21 is electrically connected to the control module 22. The control module 22 is arranged corresponding to the flexible touch screen 21. It is convenient that the part of the flexible touch screen 21 extending into the first space 2322 connects to the control module 22.

In other embodiments, an inserting hole 2331 is defined in the baffle 233. An inserting tab 2341 is positioned at an end of the support 234. The inserting tab 2341 is inserted in the inserting hole 2331 to fix the support 234 on the baffle 233. Then the support 234 and the control module 22 are fixed in the first space 2322. In use of the selfie stick 100, the control module 22 is prevented from damage for shaking. It is beneficial to improve service life of the control module 22.

In other embodiments, the control module 22 includes a circuit board 221 and a processing chip 222. The circuit board 221 is operated to support the processing chip 222. The processing chip 222 is electrically connected with the flexible touch screen 21. The processing chip 222 is operated to process touching signals generated by the flexible touch screen 21 in accordance with the touch operations to generate control signals.

The control module 22 further includes a wireless connector for wirelessly communicating with the photographic device 200. The wireless connector is mounted on the circuit board 221. The wireless connector is electrically coupled with the processing chip for transmitting the control signals to the photographic device 200. Connections, such as Bluetooth connectivity, WiFi networking, ZigBee (ZigBee Wireless Networking) connectivity, or NFC (Near Field Communication), are adopted by the wireless connector.

In other embodiments, a mounting hole 2342 is defined in the support 234. The circuit board 221 is fixed to the mounting hole 2342 by a first fastener (not illustrated). Inner threads are formed on an inner surface of the mounting hole 2342. The first fastener may be a screw or a screw bolt. The mounting hole 2342 may be formed in an installation post. There may be multiple mounting holes 2342.

The support 234 may further provides a fixing post 2343 for fixating the circuit board 221, thereby reducing assembly difficulty.

In other embodiments, a limiting board 235 is formed in the first space 2322. The limiting board 235 is operated to limit the control module 22. The limiting board 235 engages with the support 234 to fix the control module 22. The control module 22 may be further prevented from damage for shaking thanks to the limiting board 235. The limiting board 235 is connected with the baffle 233 and the fixing end 232.

In other embodiments, the handle 2 further includes a coupling member 25. The coupling member 25 includes a first end 251 and a second end 252. The first end 251 extends into the first space 2322 to be fixed at the fixing end 232. The second end 252 is connected to the connecting part 3.

A plurality of first fixing holes 2324 is defined in the fixing end 232. A plurality of second fixing holes 2511 are defined in the first end 251 and corresponds to the plurality of first fixing holes 2324 one to one. Fixing and positioning for the coupling member 25 and the handling member 23 each other may be achieved, via a fixing member passing through the corresponding first fixing hole 2324 and the second fixing holes 2511.

In other embodiments, the handle 2 further includes a connecting member 26. The connecting member 26 is sleeved on outsides of the fixing end 232 for fixing the coupling member 25 to the fixing end 232. In assembly, the first end 251 of the coupling member 25 extends into an interior of the fixing end 232 (also named as first space 2322) firstly. Then the connecting member 26 is sleeved on the outsides of the fixing end 232 for fixing (such as fastening or clamping) the coupling member 25 and the fixing end 232.

A connection relation between the connecting member 26 and the fixing end 232 may be a threaded connection, clamping connection, or the like.

In other embodiments, the connecting member 26 includes a stop block 261 formed at an end thereof. An outer diameter of the first end 251 is greater than that of the second end 252 to form a stepped surface 2510. The stepped surface 2510 rests against the stop block 261. The stop block 261 of the connecting member 26 rests against the stepped surface 2510 of the coupling member 25 to avoid the coupling member 25 deviating from the handling member 23.

In other embodiments, an outer diameter of the holding end 231 is greater than that of the fixing end 232. The touching member 24 is clamped between the connecting member 26 and the holding end 231. The connecting member 26 engages with the holding end 231 to position the touching member 24, to avoid a movement of the touching member 24 when the selfie stick 100 in use. Then scratches for the flexible touch screen 24 may be avoided from the touching member 24 to ensure the service life of the selfie stick 100.

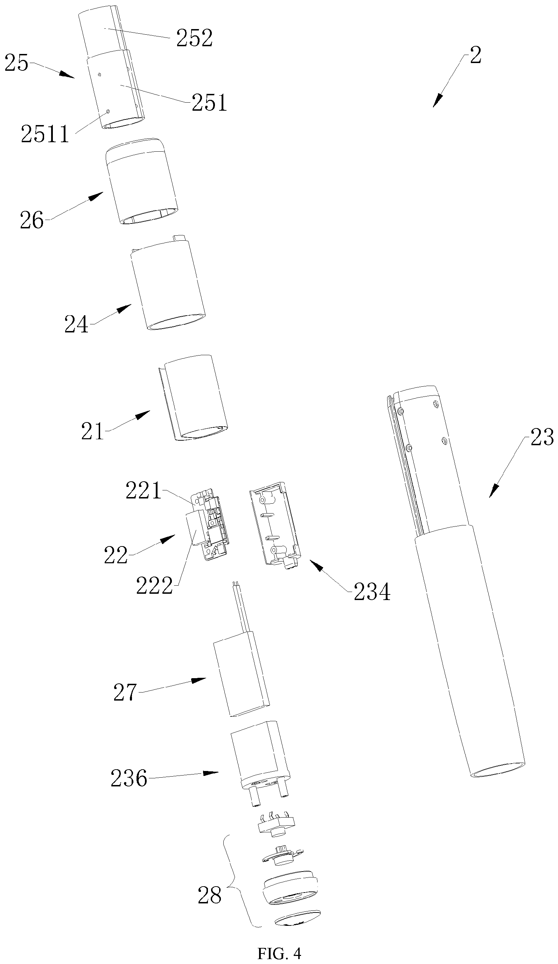

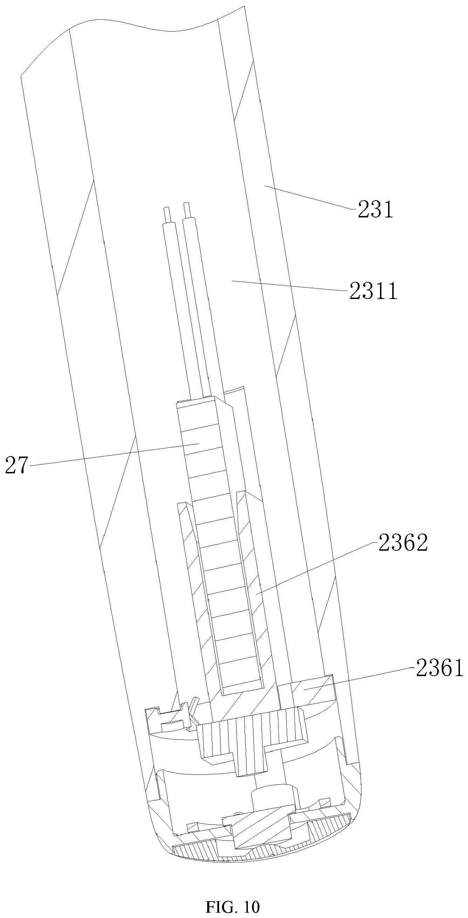

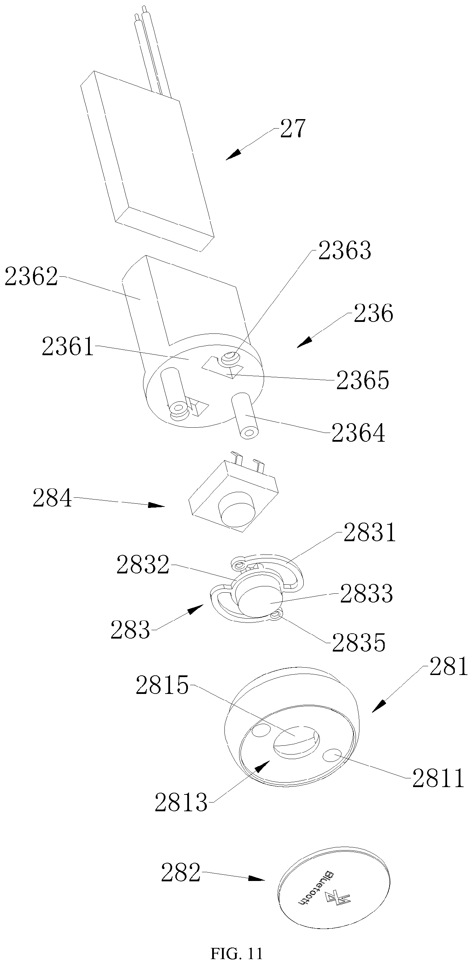

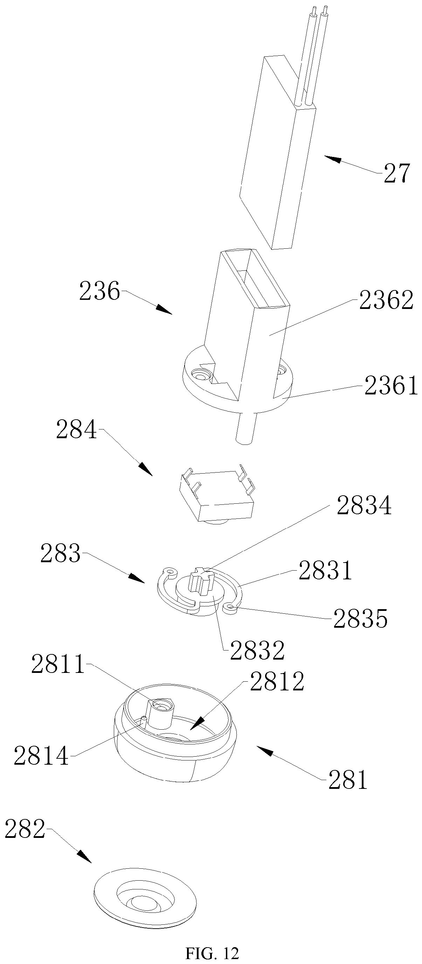

Referring to FIGS 4 to 12, as an alternative embodiment, the handle 2 further includes a battery 27. The battery 27 is operated to provide power to the control module 22 and the flexible touch screen 21. The battery 27 is mounted in the second space 2311.

In the embodiment, the battery 27 and the control module 22 are positioned in two independent spaces, respectively. Negative effects may be avoided from the heat released by the battery 27 to ensure a normal use of the selfie stick 100 and prolong the service life of the selfie stick 100.

In other embodiments, the handle 2 further includes a mounting bracket 236. The mounting bracket 236 is fixed in the second space 2311. The mounting bracket 236 includes a base board 2361 and a battery housing 2362. The battery housing 2362 is positioned on a side of the base board 2361 facing toward the baffle 233. The battery 27 is received in the battery housing 2362. The battery 27 is fixed by the battery housing 2362 to avoid shakes while using the selfie stick 100. A wire hole 2332 is defined in the baffle 233. Electric wires of the battery 27 pass through the wire hole 2332 to connect with the control module 22.

In other embodiments, a through hole 2363 is defined in the base board 2361. A fixing post 2312 is formed in the second space 2311 for connecting with the holding end 231. A second fastener (not illustrated) passes through the through hole 2363 and extends into the fixing post 2312 to fix the base board 2361 to the holding end 231. The fixing post 2312 provides a hole therein, of which a hole wall provides a screw thread. The second fastener may be a screw or a bolt. The base board 2361 may divide the second space 2311 into a first subspace and a second subspace for optimizing structural arrangement of the internal space of the handle 2. The fixing post 2312 is connected to the holding end 231.

Referring to FIGS. 4 to 12, as an alternative embodiment, a handle 2 further includes a button module 28. The button module 28 is operated to control operative modes of the control module 22, such as state on or state off of power and blue teeth. A mounting bracket 236 further includes a protruding post 2364. The protruding post 2364 is positioned on a side of the base board 2361 away from the baffle 233. The button module 28 is fixed on the protruding post 2364. The protruding post 2364 is received in the second space 2311. At least a part of the button module 28 is received in the second space 2311. The battery 27 and the button module 28 are positioned in two independent spaces by the base board 2361 respectively. The negative effects of the heat released by the battery 27 may be decreased.

In other embodiments, the button module 28 includes a bottom cover 281. A fastening hole 2811 is formed in the bottom cover 281. A third fastener (not illustrated) passes through the fastening hole 2811 and extends into the protruding post 2364 to fix the bottom cover 281 to the holding end 231. The second space 2311 is closed by the bottom cover 281. Foreign impurities may be kept from the second space 2311 by the bottom cover 281. A hole is defined in an interior of the protruding post 2364. Threads may be formed on a sidewall of the hole. The third fastener is a corresponding screw or screw bolt.

In other embodiments, the button module 28 further includes a button 282, a pressing member 283, and a switch 284. The switch 284 is mounted on a side of the base board 2361 facing toward the bottom cover 281. The bottom cover 281 includes an inner side 2812 facing toward the mounting bracket 236 and an outer side 2813 away from the mounting bracket 236. The pressing member 283 includes a body and an elastic arm 2831. The body includes a substrate 2832, a convex plate 2833, and a resisting post 2834. The convex plate 2833 and the resisting post 2834 are positioned at opposite sides of the substrate 2832 respectively. The elastic arm 2831 is capacity of being elastically deformed. The pressing member 283 is mounted on the inner side 2812 by the elastic arm 2831, to enable the body to move relative to the bottom cover 281. The convex plate 2833 faces toward the bottom cover 281. The resisting post 2834 faces toward the switch 284. The button 284 is mounted on the outer side 2813. The convex plate 2833 of the pressing member 283 passes through the through hole 2815 of the bottom cover 281 to neighbor with the button 282. The button 282 will rest against the convex plate 2833 to move the body toward the switch 284 when pressing the button 282. The resisting post 2834 rests against the switch 284 for triggering the switch 284. The elastic arm 2831 will enable the body to return its original position when releasing the button 282.

A fixing hole 2835 is defined in an end of the elastic arm 2831 away from the substrate 2382. A positioning post 2814 is positioned on the inner side 2812 of the bottom cover 281. The positioning post 2814 passes through the fixing hole 2835 to fix the bottom cover 281 and the elastic arm 2831.

A wire groove 2365 is defined in the base board 2361. Electric wires of the switch 284 pass through the wire groove 2365 and the wire hole 2332 to connect with the control module 22.

Referring to FIGS. 1 and 2, as an alternative embodiment, the holding bracket 1 includes a bracket body 11 and a motor 12. The bracket body 11 is operated to clamp the photographic device 200. The motor 12 is operated to move or rotate the bracket body 11 and therefore move or rotate the photographic device 200. Then, camera position and orientation of the photographic device 200 may be controlled.

In other embodiments, there are a plurality of light sources (not illustrated) positioned on the bracket body 11. The light sources are operated to fill light while the photographic device 200 is shooting.

Referring to FIGS. 1 to 16, a method for controlling a photographic device using a selfie stick is further provided by the exemplary embodiment of the present disclosure. The selfie stick 100 described in above embodiments may be applied in the method for controlling the photographic device 200.

The method for controlling a photographic device using a selfie stick, includes:
the flexible touch screen 21 of the handle 2 of the selfie stick 100 is touched;
the flexible touch screen 21 detects touch operations thereon and generates touch signals;
and the control module 22 generates control signals in accordance with the touch signals and sends to the photographic device 200 for controlling the photographic device 200.

In the embodiment, various shooting parameters or functions may be adjusted via different operations on the flexible touch screen 21 in the method for controlling the photographic device using the selfie stick, such as focal length, diaphragm, color, and flash, to achieve better shooting experience for users. The touch operations may be feedback by a display interface of the photographic device 200 at any time.

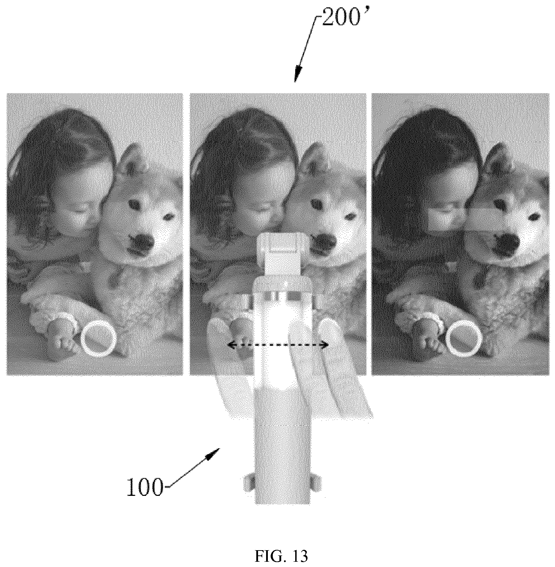

As an alternative embodiment, a photographic filter of the photographic device 200 will be switched when the touch operation is a horizontal slide operation. For example, black and white, miniature forest, nostalgia, photo processing, fade, years, photo processing. As illustrated in FIG. 13, a pattern indicated by a label 200' is a view displayed by the photographic device 200. The touch operation for the horizontal slide operation is similar to screen switching. It is beneficial to improve user experience.

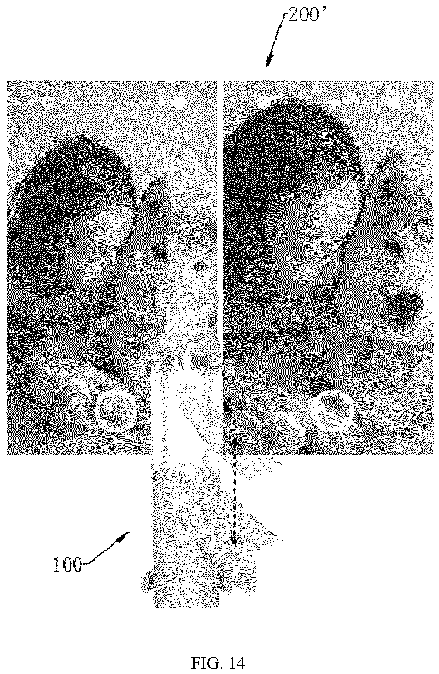

As an alternative embodiment, a focal length of the photographic device will be adjusted in accordance with the control signals when the touch operation is a vertical slide operation. For example, the focal length is increased with an upward sliding; the focal length is decreased with a downward sliding, or vice versa. As illustrated in FIG. 14, a pattern indicated by a label 200' is a view displayed by the photographic device 200. The touch operation for the vertical sliding operation is appropriate to a pattern displayed by the photographic device 200 for showing the focal length values. It is beneficial to improve using experience for users.

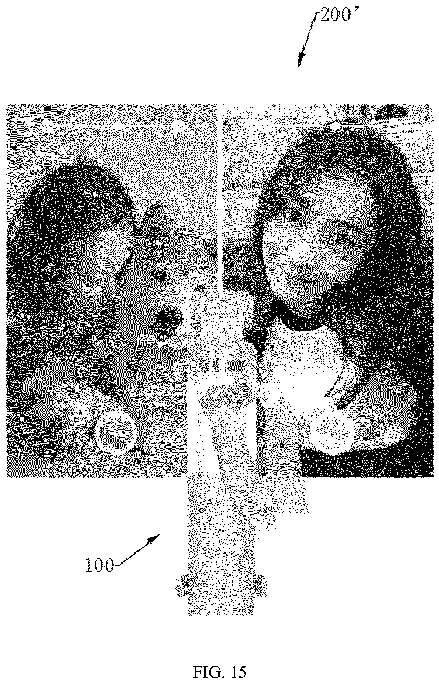

As an alternative embodiment, the photographic device 200 will switch between a front camera and a rear camera in accordance with the control signals when the touch operation is a double-click operation. For example, the front camera may be switched to the rear camera, or the rear camera may be switched to the front camera upon double-click operation. As illustrated in FIG. 15, a pattern indicated by a label 200' is a view displayed by the photographic device 200.

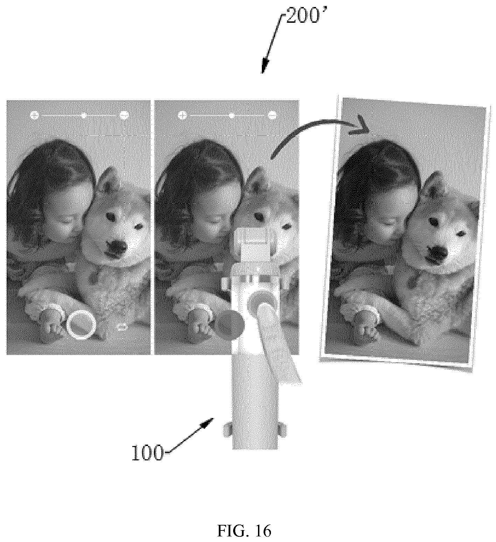

As an alternative embodiment, the photographic device 200 will take a picture in accordance with the control signal when the touch operation is a long-press operation. Since that a long-press operation is applied to correspond with the control signal for shooting, mistake operations caused by mistake touching may be avoided. As illustrated in FIG. 16, a pattern indicated by a label 200' is a view displayed by the photographic device 200.

As an alternative embodiment, the touching operations include three levels: the first level refers to gestures for activating operation commands; the second level refers to gestures for choosing sub-modes under single mode; the third level refers to gestures for adjusting optimizing degree, parameters of the adjusting mode under the sub modes.

### For example:

The photographic device 200 will enter a corresponding main mode when the touch operation is a multi-point touch operation. The main mode includes a shooting mode, and/or a filling light mode, and/or a camera adjusting mode, and/or a focal length adjusting mode. The multi-point touch includes at least two points tap, such as a double-click operation for entering the shooting mode, a three-point operation for entering the filling light mode, a four-point operation for entering the camera adjusting mode, and a five-point operation for entering the focal length adjusting mode.

In one embodiment, the photographic device 200 will choose a sub-mode subordinated to a chosen main mode according to the control signals when the touch operation is a horizontal slide operation. For example, in a main mode for shooting mode, a mode may be chosen from different selfie modes via horizontal slide operations, the different selfie modes including white and black, fade, facial beautification.

Furthermore, the shooting parameters will be adjusted by the photographic device 200 in the chosen sub-mode according to the control signal when the touch operation is a vertical slide operation. For example, facial beautification level from 1 to 9 is adjusted in the beautification mode which is under the shooting mode; contrast ratio of black and white is adjusted in the black and white mode.

In another embodiment, with regard to the main modes without sub-modes, such as the filling light mode, camera adjusting mode, corresponding shooting parameters will be directly adjusted under the main modes by the photographic device 200 in accordance with the control signals when the touch operation is a vertical slide operation or/and horizontal slide operation. There is no need to enter the sub-mode any more (but enter the sub-mode of the described embodiments above). For example, after entering the filling light mode, intensity of filling light is adjusted via a swipe-up operation or swipe-down operation, or a left swipe or right swipe. After entering the camera adjusting mode, left or right angle of the camera is adjusted via a left swipe or right swipe, up or down angle for the camera adjusted via a swipe-up operation or swipe-down operation. After entering the focal length adjusting mode, focal length is adjusted via a swipe-up operation or swipe-down operation.

As an alternative embodiment, no control signal will be generated when the flexible touch screen 21 detecting a single-point sliding operation (such as a single-point horizontal sliding operation or single-point vertical sliding operation). Mistake touching may be avoided during the sliding.

Normal control signals will be generated and sent out when the flexible touch screen 21 detects a double-click sliding operation (such as a double-click horizontal sliding operation or double-click vertical sliding operation). For example, two fingers (usually being a thumb and a forefinger) touch at two positions (like up and down positions) on the flexible touch screen 21 at the same time, respectively. Then the operation is identified as a sliding operation (horizontal movement or vertical sliding).

As an alternative embodiment, the photographic device 200 will take a picture in accordance with the control signals when the touching operation is a single-point operation. The touching operation of the single point may be done after adjustments for the photographic device 200, also may be directly done without adjustments for the photographic device 200.

The embodiments of the present disclosure have been described in detail above. The specific principles of the present disclosure and the implementation manners have been described in specific examples. The above embodiments are only used to help understand the method of the present disclosure and its core ideas. At the same time, persons of ordinary skill in the art, based on the idea of the present disclosure, will have changes in specific implementation manners and application ranges. In summary, the contents of the present specification should not be construed as limiting the present disclosure.

## Claims

1. A selfie stick comprising:
a holding bracket operated to hold a photographic device;
a handle comprising a flexible touch screen and a control module, the flexible touch screen operated to detect touch operations, and the control module electrically coupled to the flexible touch screen and operated to send control signals to the photographic device according to the touch operations; and
a connecting part connecting the holding bracket and the handle.

2. The selfie stick of claim 1, wherein the handle comprises a handling member which comprises a holding end and a fixing end, wherein the fixing end is positioned between the holding end and the connecting part, the flexible touch screen positioned around an outer surface of the fixing end.

3. The selfie stick of claim 2, wherein the handle comprises a touching member sleeved on an outside of the flexible touch screen for protecting the flexible touch screen.

4. The selfie stick of claim 2 or claim 3, wherein an interior of the fixing end defines a first space, a slot defined in the fixing end, and the flexible touch screen extending into the first space via the slot.

5. The selfie stick of claim 4, wherein an interior of the holding end defines a second space, wherein the handle comprises a baffle for separating the first space from the second space.

6. The selfie stick of claim 5, wherein the handle further comprises a support, the support is mounted in the second space for supporting the control module.

7. The selfie stick of claim 6, wherein an inserting hole is defined in the baffle, an inserting tab positioned on an end of the support, the inserting tab inserted into the inserting hole.

8. The selfie stick of claim 6 or claim 7, wherein the control module comprises a circuit board and a processing chip, the circuit board operated to support the processing chip, and the processing chip electrically coupled with the flexible touch screen for processing touching signals detected on the flexible touch screen and generating the control signal.

9. The selfie stick of claim 8, wherein a mounting hole is defined in the support, the circuit board fixed to the mounting hole by a first fastener.

10. The selfie stick of claim 4, wherein the handle further comprises a coupling member which comprises a first end and a second end, wherein the first end extends into the first space to be fixed at the fixing end, the second end connected to the connecting part.

11. The selfie stick of claim 10, wherein the handle further comprises a connecting member sleeved on outsides of the first end and the fixing end for fixing the coupling member to the fixing end.

12. The selfie stick of claim 11, wherein a stop block is formed at an end of the connecting member, an outer diameter of the first end is greater than that of the second end to form a stepped surface that rests against the stop block.

13. The selfie stick of claim 11 or claim 12, wherein an outer diameter of the holding end is greater than that of the fixing end, and the touching member is clamped between the connecting member and the holding end.

14. The selfie stick of claim 5, wherein the handle further comprises a battery that is mounted in the second space.

15. The selfie stick of claim 14, wherein the handle further comprises a mounting bracket fixed in the second space, wherein the mounting bracket comprises a base board and a battery housing, the battery housing positioned on a side of the base board facing toward the baffle, the battery received in the battery housing.

16. The selfie stick of claim 15, wherein a through hole is defined in the base board, a fixing post formed in the second space for connecting with the holding end, and a second fastener passing through the through hole and extending into the fixing post to fix the base board to the holding end.

17. The selfie stick of claim 15 or claim 16, wherein a handle further comprises a button module operated to control operative modes of the control module, wherein the mounting bracket further comprises a protruding post positioned on a side of the base board away from the baffle, the button module fixed on the protruding post.

18. The selfie stick of claim 17, wherein the button module comprises a bottom cover that provides a fastening hole, a third fastener passing through the fastening hole and extending into the protruding post to fix the bottom cover to the holding end.

19. The selfie stick of claim 18, wherein the button module comprises a button, a pressing member, and a switch, wherein the switch is mounted on a side of the base board facing toward the bottom cover, wherein the bottom cover comprises an inner side facing toward the mounting bracket and an outer side facing away from the mounting bracket, the pressing member mounted on the inner side by an elastic arm, the button mounted on the outer side, a protruding plate of the pressing member passing through the through hole of the bottom cover to neighbor with the button.

20. The selfie stick of claim 1, wherein the holding bracket comprises bracket body and a motor, the bracket body operated to clamp the photographic device, and the motor operated to move or rotate the bracket body.

21. A method for controlling a photographic device using a selfie stick, comprising:
touching the flexible touch screen of a handle of the selfie stick;
by a flexible touch screen, detecting touch operations thereon and generating touch signals; and
by a control module, generating control signals in accordance with the touch signals and sending the control signals to the photographic device for controlling the photographic device.

22. The method of claim 21, wherein a photographic filter of the photographic device is switched according to the control signals when the touch operation is a horizontal slide operation.

23. The method of claim 21, wherein a focal length of the photographic device is adjusted according the control signals when the touch operation is a vertical slide operation.

24. The method of claim 21, wherein the photographic device is switched between a front camera and a rear camera according to the control signals when the touch operation is a double-click operation.

25. The method of claim 21, wherein the photographic device takes a picture according to the control signals when the touch operation is a long-press operation.

26. The method of claim 21, wherein the photographic device enters a corresponding main mode when the touch operation is a multi-point touch operation, the main mode comprising a shooting mode, and/or a filling light mode, and/or a camera adjusting mode, and/or a focal length adjusting mode.

27. The method of claim 26, wherein the photographic device chooses a sub-mode subordinated to a chosen main mode according to the control signals when the touch operation is a horizontal slide operation.

28. The method of claim 27, wherein the shooting parameters are adjusted by the photographic device in the chosen sub-mode according to the control signals when the touch operation is a vertical slide operation.
